# EUROPEAN PATENT SPECIFICATION

(11) **EP 0 495 559 B1**
(45) Date of publication and mention of the grant of the patent: **05.10.1994**
(21) Application number: 92200915.4
(22) Date of filing: 12.01.1988
(51) Int. Cl.: H01S 3/085, H04B 10/00, H01S 3/133

(54) **Hybrid laser for optical communications**
Hybridlaser für optisches Nachrichtenwesen
Laser hybride pour la communication optique

(30) Priority: 21.01.1987 US 5672
(43) Date of publication of application: 22.07.1992
(62) Divisional of application: 88300205.7
(73) Proprietor: AT&T Corp., New York, NY 10013-2412 (US)
(72) Inventor: Blonder, Greg E., Maplewood, New Jersey 07040 (US); Henry, Charles Howard, Skillman, New Jersey 08558 (US); Kazarinov, Rudolf F., Martinsville, New Jersey 08836 (US); Olsson, Nils Anders, Summit, New Jersey 07901 (US); Orlowsky, Kenneth Jeffrey, Oviedo FL 32765 (US)
(74) Representative: Watts, Christopher Malcolm Kelway, Dr.

(56) References cited:
- EP-A- 0 006 372
- WO-A-86/02208
- DE-A- 3 509 354
- FR-A- 2 376 536
- GB-A- 2 115 218
- TELECOM REPORT (BEIHEFT) vol. 6, April 1983, PASSAU, DE pages 90 - 96; H.L. ALTHAUS ET AL.: 'Lasersender in Modulbauweise'

## Description

### Background of the Invention

Communications technology based on the use of optical radiation as an information carrier medium has rapidly reached a point of large-scale commercial utilization, augmenting and often supplanting more traditional approaches based on wire or microwaves. Commercial viability of optical communications may be attributed to the convergence of a number of developments such as, most prominently, the perfection of low-loss optical fibers, of light sources in the form of semiconductor light-emitting diodes and lasers, and of high-speed photodetectors. Particular attention is paid in the following to laser light sources and their suitability for use in optical communications systems.

Prominent among communications lasers are those commonly designated as distributed-feedback (DFB) lasers as predicated on feedback induced by periodic variations in optical characteristics along an active medium. In this respect see, e.g., U. S. patent 3,760,292, issued September 18, 1973 to H. W. Kogelnik et al., and U. S. patent 3,868,589, issued February 25, 1975 to S. Wang. In an alternative laser design, a structure of periodic variations of optical properties (e.g., in the form of a grating) is placed beyond rather than alongside an active medium, thereby acting as a Bragg reflector. For example, as disclosed in U. S. patent 4,286,838, issued September 1, 1981 to J.-P. Huignard, a device may include a semiconductor active portion which is optically coupled to a polymeric reflector portion. Or, as disclosed in U. S. patent 4,464,762, issued August 7, 1984 to K. Furuya, a silicon dielectric compound is suitable for the fabrication of a distributed Bragg reflector (DBR) coupled to a semiconductor active medium.

Preferably, as disclosed by Y. Abe et al., "GaInAsP/InP Integrated Laser with Butt-jointed Built-in Distributed-Bragg-reflection Waveguide", *Electronics Letters*, Vol 17(1981), pp. 945-947, field profiles and refractive indices of the active and reflector portions are matched in the interest of providing good coupling and low interface reflectivity.

Suitability of a laser for communications purposes depends on a number of criteria such as, e.g., significant suppression of nonlasing modes; in this respect see, e.g., J. M. Hammer et al., "Single-wavelength Operation of the Hybrid-external Bragg-reflector-waveguide Laser Under Dynamic Conditions", *Applied Physics Letters*, Vol. 47 (1985), pp. 183-185. Among other requirements for optical communications are narrow linewidth for coherent applications, low chirp when dispersive transmission media are employed, and precisely selected wavelength in wavelength-multiplexed systems.

### Summary of the Invention

From the point of view of ease of manufacture there are distinct advantages in assembling lasers by combining a separately manufactured reflector portion with an active, amplifying portion. Such lasers, conveniently designated as hybrid distributed-Bragg-reflector lasers, are contrasted with distributed-feedback lasers as well as with monolithic distributed-Bragg-reflector lasers as made by layer deposition on a single substrate. Accordingly, hybrid distributed-Bragg-reflector lasers deserve particular consideration for communications use.

It has been discovered that hybrid distributed-Bragg-reflector lasers may undergo mode instabilities which, unless prevented or rendered harmless, adversely affect transmission error rate. Mode instabilities may be prevented by suitable setting of a laser operating parameter such as, e.g., laser temperature. In accordance with the invention, mode instabilities are rendered harmless by using a sufficiently broad-band Bragg reflector.

In the latter approach, laser operating point can change from one mode to a neighboring mode. This approach is of particular interest where mode dispersion is of limited concern such as, e.g., in cases of transmission over short distances (as, e.g., in local-area-network applications), or of transmission by means of optical fiber waveguides near the zero-dispersion point. The former, single-mode approach has the further advantages of providing for narrow linewidth and low chirp.

Hybrid distributed-Bragg-reflector lasers in accordance with the invention can be implemented using a dielectric reflector component such as, e.g., a silica-silicon nitride waveguide on a silicon substrate.

### Brief Description of the Drawing

FIG. 1 is a schematic, greatly enlarged side view of a distributed-Bragg-reflector-laser assembly, representing a preferred embodiment of the invention;
FIG. 2 is schematic cross-sectional view of the Bragg-reflector portion of the laser assembly shown in FIG. 1;
FIG. 3 is a schematic, greatly enlarged view of an alternative to the embodiment of a distributed-Bragg-reflector-laser assembly of FIG. 1, the laser being bonded to a silicon substrate;
FIG. 4 is a schematic cross-sectional view of the active-layer portion of the laser assembly shown in FIG. 3;
FIG. 5 is a schematic cross-sectional view of a laser-active portion aligned on a V-grooved substrate;
FIG. 6 is a schematic representation of a transmitter for optical communications in accordance with the invention;
FIG. 7 is a schematic representation of a system for optical communications;
FIG. 8 is a gain-versus-optical-frequency diagram;
FIG. 9 is a gain-versus-optical-frequency diagram as applicable to a preferred embodiment of the invention;
FIG. 10 is a schematic diagram showing a curve corresponding to threshold current as a function of laser temperature, such curve being helpful for determining a preferred laser parameter;
FIG. 11 is a schematic cross-sectional view of the Bragg-reflector portion of an embodiment of the invention, including heating means and an additional material for controlling a laser operating parameter;
FIG. 12 is a schematic top view of a Bragg-reflector portion including optical taps as can be used for continuous setting of a laser operating parameter;
FIG. 13 is a diagram based on measurements carried out on a Bragg-reflector chip as may be incorporated in a device in accordance with the invention, such diagram showing transmission and reflection curves for such reflector chip;
FIG. 14 is a diagram showing lasing spectra as experimentally determined for a laser and, for the sake of comparison, for a laser without a Bragg-reflector grating. The diagram shows laser output power as a function of laser frequency for different laser drive currents under direct-current operating conditions;
FIG. 15 is a diagram showing a lasing spectrum as experimentally determined for a laser and, for the sake of comparison, for a laser without a Bragg-reflector grating. The diagram shows laser output power as a function of laser frequency under conditions of modulation with a 1-gigahertz signal; and
FIG. 16 is a plot of bit error rate as a function of received power as experimentally determined using a transmitter for transmission at 1.7 gigabits per second over a dispersive fiber for distances of 10 meters and 82.5 kilometers, transmission being at a wavelength of approximately 1.52 micrometer, and the zero-dispersion point of the fiber being at approximately 1.3 micrometer.

### Detailed Description

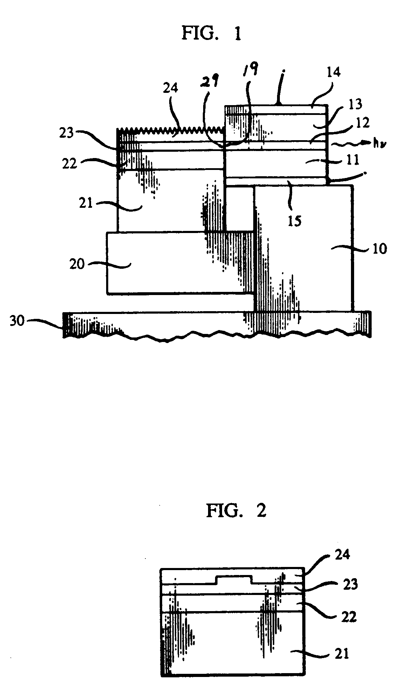

FIG. 1 shows substrate 11 supporting laser active layer 12, such substrate typically including a buffer layer. FIG. 1 further shows upper cladding layer 13, and contact layers 14 and 15 with soldered electrical wire connections. Contact layer 15 also is in physical contact with submount 10 which, in turn, is attached to thermoelectric cooler 30.

Shown further is a Bragg reflector comprising substrate 21, cladding layers 22 and 24, and waveguide layer 23; the free surface of cladding layer 24 is shown bearing a diffraction grating which, during laser operation, serves as a Bragg-reflection element. Alternatively, a diffraction grating may be present, e.g., at the interface of layers 23 and 24, or at the interface of layers 23 and 22. Other buried-grating arrangements are not precluded. The Bragg reflector and the laser-active portion are shown having respective facets 29 and 19 in a facing relationship.

Substrate 21 is attached to submount 20 which in turn is attached to submount 10. Cooler (or heater) 30 serves to control laser temperature, thereby influencing the laser operating point; influence is the stronger the more diverse the materials of the laser active component and the Bragg-reflector component of a hybrid assembly. Excellent control is obtained, e.g., when Group III-V materials are used for the former, and silicon-based dielectric materials for the latter. As an alternative to temperature control of an entire laser assembly, heating or cooling may be applied selectively, e.g., to the laser-active portion alone, or to the Bragg-reflector portion alone.

Preferably, in the interest of minimizing Fabry-Perot modes and interface reflections, an anti-reflection coating is applied to facet 19 of the laser-active portion. Such a coating may be applied also to facet 29 of the Bragg-reflector portion.

Typical material compositions are n-doped indium phosphide for substrate 11, n-doped indium gallium arsenide phosphide for the active layer 12, and p-doped indium gallium arsenide phosphide for the upper cladding layer 13. Conveniently, the reflector substrate 21 is made of silicon, and the cladding layer 22 of oxidized silicon. Preferred thickness of layer 22 is sufficient to essentially prevent leakage of the optical field into the silicon substrate; a thickness of approximately 6 micrometers is adequate in this respect. Typical materials for the reflector waveguide layer 23 are silicon nitride or phosphosilicate glass, and silica glass for the cladding layer 24. The submounts 10 and 20 are made of a material having high thermal conductivity. Particularly suitable in this respect are silicon and beryllium oxide.

FIG. 2 shows layers 21, 22, 23, and 24 as described above in connection with FIG. 1. Waveguide layer 23 is shown as having rib structure. Typical waveguide layer thickness is approximately 120 nanometers as measured under the rib, and approximately 110 nanometers to both sides of the rib. The width of the rib may be approximately 3 micrometers. (Such rib structure is conveniently made by deposition of a 120-nanometer layer, followed by etching of a mesa in the presence of a photodefined mask covering the rib.) Layer 22 may have a thickness of approximately 5 micrometers, and layer 24 a thickness of 0.3 to 0.8 micrometer.

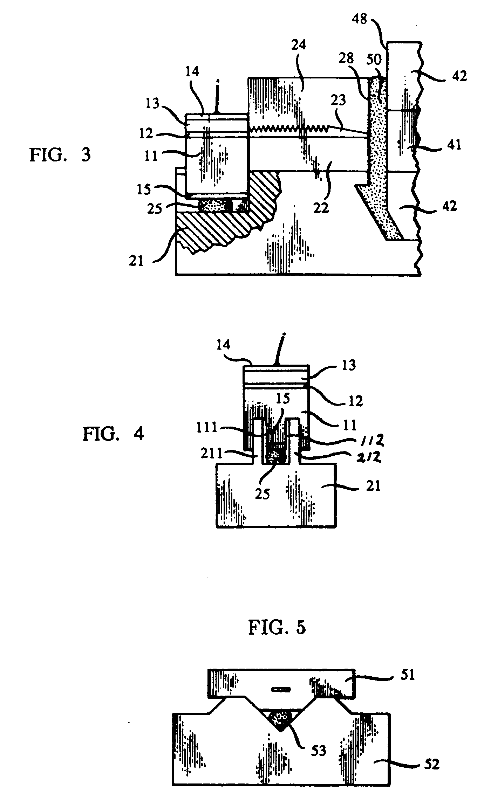

FIG. 3 and 4 show a distributed-Bragg-reflector laser having a reflector portion and a laser-active portion as described above in connection with FIG. 1 and 2. However, now the laser-active portion is attached to silicon substrate 21 which, via solder 25, and due to its high thermal conductivity, also serves as a heat sink.

An optical fiber having a core portion 41 and a cladding portion 42 is shown aligned with the Bragg-reflector portion, alignment between the fiber and the laser being facilitated by placement of the fiber in a selectively etched V-groove in the substrate. Selective surface etching also facilitates alignment of the laser-active portion with the reflector portion; here, matching is between rails 211 and 212 on substrate 21, and grooves 111 and 112 in the laser substrate 11. As shown, both vertical and lateral alignment is achieved by selectively etched rail and groove surface features, and the remaining degree of freedom can be used for butting the laser-active portion against the Bragg-reflector portion. For a survey of applicable silicon etching technology see, e.g., K. E. Petersen, "Silicon as a Mechanical Material", *Proceedings of the IEEE*, Vol. 70 (1882), pp. 420-457.

Alignment resulting from matched, selectively etched features is applicable also when a laser-active portion first is attached to a silicon submount, followed by positioning of such submount relative to a Bragg-reflector portion. This approach may be used with laser-active portions mounted "junction-down"; in this respect see, e.g., Y. Seiwa et al., "High Power CW Operation over 400 mW on Five-stripe Phase-locked Laser Arrays Assembled by New Junction Down Mounting", *Journal of Applied* *Physics*, Vol. 61 (1987), pp. 440-442.

Waveguide 23 is shown having an optionally tapered portion extending beyond the reflector grating; such tapered portion can serve to broaden an optical mode for ready coupling into the optical fiber. Further in the interest of good coupling and minimized reflection at the laser-fiber interface, the gap between reflector facet 28 and fiber facet 48 preferably is filled with an index-matching medium 50 such as, e.g., an epoxy whose refractive index is closely matched to the refractive indices of the laser and fiber waveguide materials. Use of such a medium is particularly advantageous for minimizing the optical effects of unavoidable surface roughness at the etched reflector surface 28. Since efficacy of such a medium depends on a close match between the refractive indices of laser waveguide material and, typically, silica fiber material, choice of silicon-based dielectric materials for Bragg reflectors is particularly advantageous.

FIG. 5 shows alignment of a laser-active portion 51 by means of a V-groove surface feature of silicon substrate 52, with solder 53 used for contact. This represents an alternative to the grooves-and-rails approach of FIG. 4, also providing for lateral as well as vertical alignment.

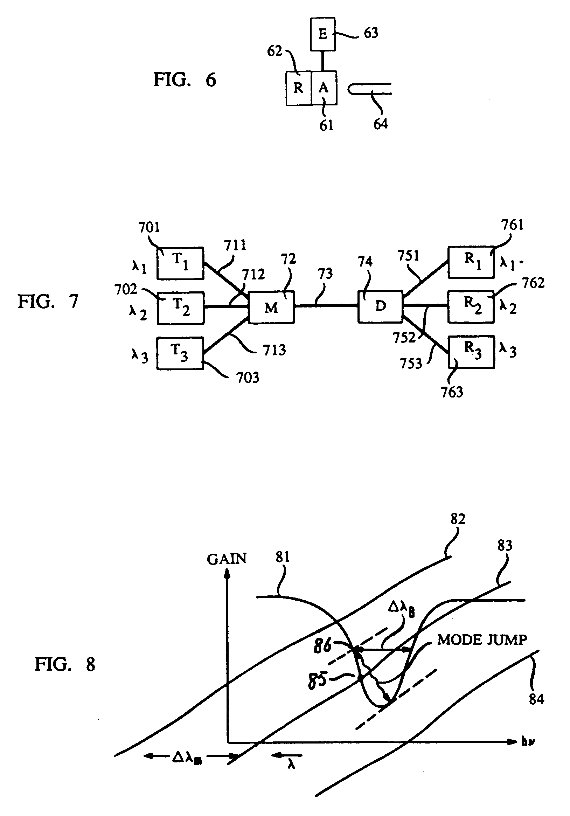

FIG. 6 shows distributed-Bragg-reflector-laser active portion 61, reflector portion 62, and electronic unit 63 connected to laser active portion 61, representing a transmitter in accordance with the invention. As shown, lasers of the invention are particularly suited for direct electrical modulation; however, use of an optical modulator external to the laser is not precluded. Coupling to an optical fiber 64 may be at the laser-active portion as shown, or else at the reflector portion as shown in FIG. 3.

FIG. 7 shows transmitters 701, 702, and 703 for operation at respective wavelengths λ₁, λ₂, and λ₃. Optical fibers 711, 712, and 713 connect transmitters 701, 702, and 703 to multiplexer 72 to which optical transmission line 73 is connected. Transmission line 73 is connected also to demultiplexer 74 which, under operating conditions, separates signals at wavelengths λ₁, λ₂, and λ₃ for further transmission over optical fibers 751, 752, and 753 to respective receivers 761, 762, and 763. Since hybrid distributed-Bragg-reflector lasers are readily manufactured to small wavelength tolerances, such lasers are particularly suited for use in wavelength-multiplexed systems where closely-spaced channels at specified wavelengths are called for.

FIG. 8 shows a curve 81 corresponding to gain-equals-loss. (The pronounced dip in curve 81 is caused by the presence of a Bragg reflector, in whose absence the curve would be flat. The Bragg width Δλ_{B} is directly related to the coupling strength of the grating.) Also shown are phase curves 82, 83, and 84 corresponding to round trip phase of 2πN, 2π(N+1), and 2π(N+2), where N denotes an integer. (The longer the laser-active region, the closer the spacing of these curves.)

Since, in a hybrid laser under consideration, the refractive index of a laser-active medium typically has greater temperature dependence than the refractive index of the reflector medium, temperature changes lead to changes in the position of curves 82, 83, and 84 relative to curve 81, resulting in a change of operating point. If temperature changes by a sufficient amount (in the case of the laser of Examples 1 and 2 below by approximately 14 degrees C), the laser operating point jumps from one of the curves 82, 83, and 84 to another, and mode instability is observed. The operating point is also influenced by changes in mechanical alignment of laser components, and there may be other influences in long-term operation.

The Bragg width Δλ_{B} is less than the mode spacing Δλₘ of the laser-active portion, and a laser operating parameter is chosen, once or repeatedly, so as to result in a preferred laser operating point 85 away from the point 86 corresponding to mode instability. Preferably in this case, mode spacing is less than 90 percent of the Bragg width.

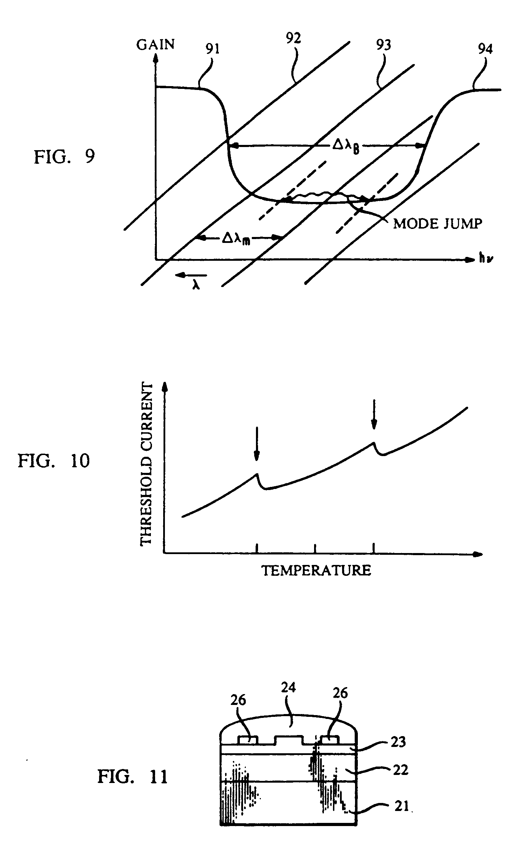

FIG. 9 shows a curve 91 corresponding to gain-equals-loss in a preferred embodiment of the invention, as well as phase curves 92, 93, and 94 corresponding to round trip phase of 2πN, 2π(N+1), and 2π(N+2). In accordance with this embodiment of the invention, the Bragg width Δλ_{B} is greater than the mode spacing Δλₘ, and mode transitions do not result in significant gain changes. Preferred Bragg width is at least 1.1, and preferably at least 2 times (but not more than 4 times) mode spacing.

This preferred embodiment of the invention is of interest especially for communications applications where narrow linewidth and frequency stability are less critical. Low transmission error rate is obtained even though laser operation involves mode instability, provided the Bragg-reflector grating is made to have a broad reflection spectrum.

FIG. 10 illustrates determination of a preferred laser temperature on the basis of measurement of threshold current as a function of temperature. The curve of FIG. 10 can be seen to have cusps - which were found to correspond to points of mode instability. Based on such curve, a laser operating temperature can be selected away from instabilities, e.g., at or near the midpoint between cusps. (Alternatively, mode instabilities can be determined by spectral analysis of laser output.) Instead of controlling laser-temperature over-all, it is also possible to control the temperature of selected laser portions such as, e.g., the laser-active medium or the Bragg-reflector waveguide.

A similar curve can be obtained, e.g., when the independent variable is a voltage which influences the refractive index of a liquid-crystal material in contact with the Bragg-reflector grating or, possibly, of an electro-optic material. The operating point of a laser can be affected also by the distance between the laser-active portion and the Bragg-reflector portion. Further of interest in this respect is a Bragg-reflector element including a semiconductor material whose refractive index depends on carrier density as influenced by current injection.

As shown in FIG. 11, control of a laser operating parameter may involve temperature control of an auxiliary medium in contact with the Bragg-reflector grating. The cross-sectional structure shown in FIG. 11 is similar to that of FIG. 2, except that the material of layer 24 is chosen to exhibit strong changes in refractive index as a function of temperature. Chromium heater strips 26 are included to control the temperature of medium 24, thereby affecting the operating point of the laser. Transparent silicone rubber such as, e.g., Dow-Corning 684 represents a particularly effective material choice for layer 24. As an alternative to the arrangement shown in FIG. 11, a heater can be mounted on a separate substrate and placed separate from layer 23, with the space between the heater and layer 23 filled with material 24.

Furthermore, a material 24 may be chosen such that, in combination with the material of waveguide layer 23, the optical properties of the Bragg-reflector grating and the wavelength of the Bragg resonance are rendered essentially temperature-insensitive, so that temperature changes do not lead to changes in laser operating point. This aspect may be of particular advantage in coherent communications systems.

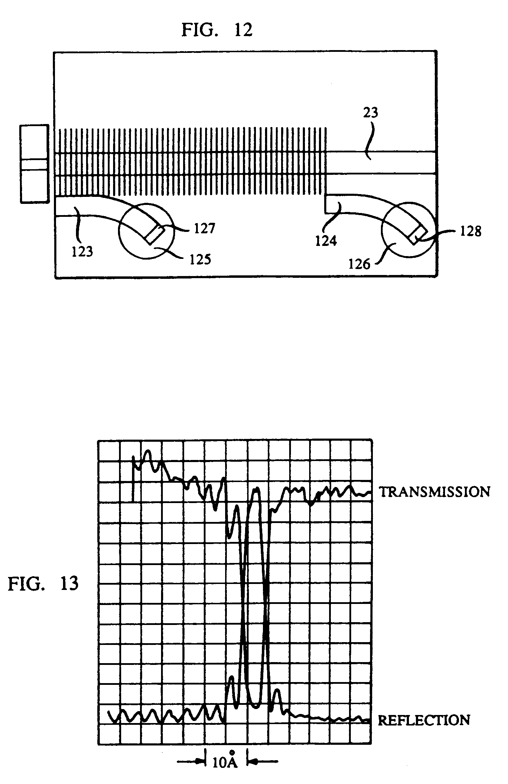

While methods for determining a laser parameter such as, e.g., laser temperature as described above in connection with FIG. 10 are best suited for use prior to laser installation, it is also possible to control a laser parameter in the course of actual laser operation. This may involve continuous or periodic monitoring and may involve the use of optical taps for measuring the power of radiation entering into and transmitted by a Bragg reflector. Such taps are shown in FIG.12 where waveguides 123 and 124 with reflecting regions 127 and 128 couple light from a Bragg-reflector waveguide 23 into detectors 125 and 126. By controlling a laser operating parameter so as to keep the power ratio essentially constant, a laser may be operated free of mode instabilities. Monitoring may be applied also to power reflected by a Bragg reflector. On account of narrow linewidth and low chirp, single-mode lasers obtained by choice of operating point away from mode instabilities as described above are particularly suited for transmission over dispersive waveguides and for coherent systems.

Example 1. A Bragg reflector was made on a silicon chip by standard chemical-vapor-deposition (CVD) processing and photodefined etching of a rib waveguide, such Bragg reflector being as shown in FIG. 1 and 2. The length of the reflector was approximately 5 mm. A reflector grating, having a period of approximately 0.5 micrometer for first-order Bragg reflection, was formed by holographic lithography and etched into the silica glass cladding layer. The spectral properties of the silicon-chip Bragg reflector were measured by transmission of white light and by reflection and transmission of tunable F-center laser light; a typical transmission-and-reflection spectrum is shown in FIG. 13. The Bragg line was found to be approximately 6 Angstroms wide and to be centered at 15182 Angstroms.

A standard channelled-substrate buried-heterostructure laser as described by D. P. Wilt et al, "Channelled-substrate Buried-heterostructure InGaAsP/InP Laser with Semi-insulating OMVPE Base Structure and LPE Regrowth", *Electronics Letters*, Vol. 22, pp. 869-870 was butt-coupled to the silicon-chip Bragg reflector; no anti-reflection coating was applied. Threshold current of the laser was found to be approximately 21 mA. (Without external feedback, threshold current was approximately 25 mA, and it is estimated that power coupling efficiency between the laser and the reflector waveguide was approximately 20 percent.) A continuous-wave spectrum of the laser was recorded at a laser current of approximately 100 mA, and the mode-suppression ratio was found to be greater than 5000 to 1.

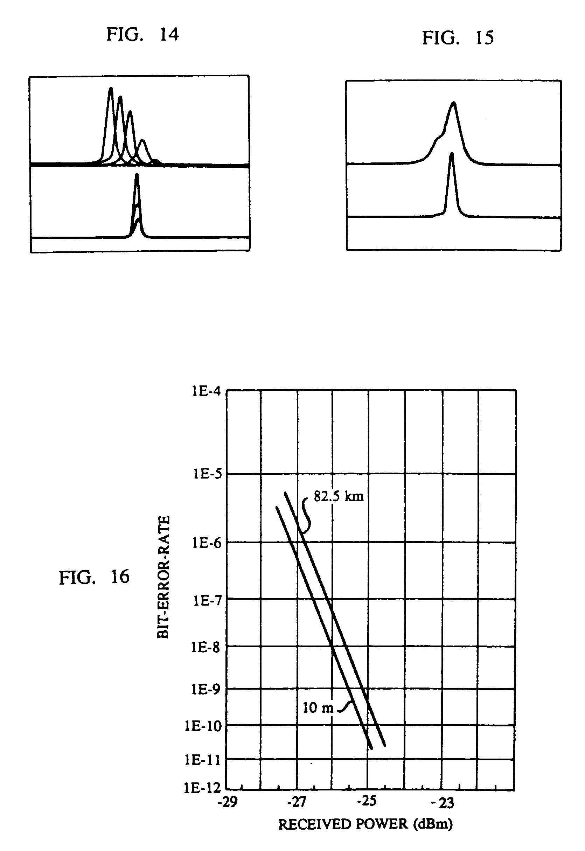

The wavelength chirping characteristics of the laser were investigated with and without the external feedback. For this purpose, spectra were recorded as the laser drive current was increased in steps of 5 mA; see FIG. 14, bottom portion for spectra obtained with external feedback, and top portion without external feedback. As can be seen from FIG. 14, top portion, the lasing wavelength of each of the lasing modes shifts approximately 0.05 Angstrom/mA or 0.65 gigahertz/mA. By contrast, as can be seen from FIG. 14, bottom portion, this shift is less than 0.03 gigahertz/mA in the presence of external feedback.

1-GHz chirp of the laser when modulated with a 45-mA peak-to peak signal is shown in FIG. 15. It can be seen that dynamic linewidth is reduced from approximately 0.75 Angstrom (top portion of FIG. 15) to less than approximately 0.2 Angstrom (bottom portion of FIG. 15) upon attachment of the external reflector.

To verify stable, single-longitudinal-mode operation and low-chirp performance of the laser, a transmission experiment was carried out at a bit rate of 1.7 Gbit/s over lengths of 10 m and of 82.5 km of optical fiber. A receiver consisting of an InGaAs avalanche photodiode was used, coupled directly to the 50-ohm input of a commercial high-speed amplifier. The laser was modulated with a 45-mA peak-to peak non-return-to-zero 2¹⁵-1 pseudo-random data signal. As shown in FIG. 16, a received power of approximately -25.2 dBm was required to realize a bit-error rate not exceeding 10⁻⁹ in the case of transmission over 82.5 km. With the laser under the same modulation conditions, but with only 10 m of fiber, a power of approximately -25.6 dBm was required for the same bit-error rate; this indicates a dispersion penalty of not more than approximately 0.4 dB.

Example 2. A laser was made as described above, except that reflector breadth was approximately 25 Angstroms as contrasted with 6 Angstroms in Example 1. Laser operation over a wide temperature range was normally single-mode, and occasionally dual-mode. Laser amplitude was observed to vary smoothly through transitions between single- and dual-mode operation, with at most 10 percent amplitude variation during transitions. Error rate experiments were performed, and the power penalty during mode transition was found not to exceed approximately 0.5 dB.

## Claims

1. An optical communications laser, said laser comprising an active portion (12) and a Bragg-reflector portion (22,23,24), and means (14,15) for supplying an electrical current to said active portion, said active portion being supported by a first substrate (11), and said Bragg-reflector portion being supported by a second substrate (21), said Bragg-reflector portion being capable of supporting at least two modes of optical radiation.

2. A laser as claimed in claim 1, said first substrate consisting essentially of a Group III-V material.

3. A laser as claimed in claim 1 or claim 2, said second substrate consisting essentially of silicon.

4. A laser as claimed in claim 3, said Bragg-reflector portion comprising a silicon-based dielectric core region (23).

5. A laser as claimed in claim 4, said core region being between cladding regions (22,24) which comprise silicon dioxide.

6. A laser as claimed in any of the preceding claims, said Bragg-reflector portion comprising a buried grating.

7. A laser as claimed in any of the preceding claims, said first substrate being attached to said second substrate.

8. A laser as claimed in claim 7, said second substrate being aligned relative to said first substrate by means of selectively-etched surface features (111,112,211,212).

9. A laser as claimed in claim 7 or claim 8 comprising a solder connection (25) between said first substrate and said second substrate.

10. A laser as claimed in any of the preceding claims, said Bragg-reflector portion comprising a tapered waveguide.

11. A laser as claimed in any of claims 1 to 6, said laser-active portion being attached to a submount which is attached to said second substrate.

12. A laser as claimed in claim 11, said submount being aligned relative to said second substrate by selectively etched surface features.

13. An optical transmitter comprising an optical communications laser as claimed in any of the preceding claims and an optical fiber connection which comprises a selectively etched surface feature for alignment of an optical fiber with said laser.

## Patentansprüche

1. Optischer Kommunikationslaser mit einem aktiven Abschnitt (12) und einem Bragg-Reflektor-Abschnitt (22, 23, 24) und einer Einrichtung (14, 15) für das Zuführen eines elektrischen Stroms zu dem aktiven Abschnitt, wobei der aktive Abschnitt von einem ersten Substrat (11) getragen wird und der Bragg-Reflektor-Abschnitt von einem zweiten Substrat (21) getragen wird, wobei der Bragg-Reflektor-Abschnitt wenigstens zwei Moden optischer Strahlung tragen kann.

2. Laser nach Anspruch 1, bei welchem das erste Substrat im wesentlichen aus einem Gruppe-III-IV-Material besteht.

3. Laser nach Anspruch 1 oder 2, wobei das zweite Substrat im wesentlichen aus Silizium besteht.

4. Laser nach Anspruch 3, bei welchem der Bragg-Reflektor-Abschnitt ein auf Silizium basierenden dielektrischen Kernbereich (23) umfaßt.

5. Laser nach Anspruch 4, bei welchem der Kernbereich zwischen Ummantelungsbereichen (22, 24) ist, die Siliziumdioxid enthalten.

6. Laser nach einem der vorstehenden Ansprüche, bei welchem der Bragg-Reflektor-Abschnitt ein vergrabenes Gitter umfaßt.

7. Laser nach einem der vorstehenden Ansprüche, bei welchem das erste Substrat an dem zweiten Substrat befestigt ist.

8. Laser nach Anspruch 7, in welchem das zweite Substrat relativ zum ersten Substrat mittels selektiv geätzter Oberflächenstrukturen (111, 112, 211, 212) ausgerichtet ist.

9. Laser nach Anspruch 7 oder 8, umfassend eine Lötmittelverbindung (25) zwischen dem ersten Substrat und dem zweiten Substrat.

10. Laser nach einem der vorstehenden Ansprüche, bei welchem der Bragg-Reflektor-Abschnitt einen sich verjüngenden Wellenleiter umfaßt.

11. Laser nach einem der Ansprüche 1 bis 6, bei welchem der laseraktive Abschnitt an einer Unterbaugruppe befestigt ist, die am zweiten Substrat befestigt ist.

12. Laser nach Anspruch 11, in welchem die Unterbaugruppe relativ zum zweiten Substrat durch selektiv geätzte Oberflächenstrukturen ausgerichtet ist.

13. Optischer Sender mit einem optischen Kommunikationslaser nach einem der vorstehenden Ansprüche und einer optischen Faserverbindung, die eine selektiv geätzte Oberflächenstruktur zum Ausrichten einer optischen Faser zu dem Laser umfaßt.

## Revendications

1. Laser de communication optique, ledit laser comprenant une partie active (12) et une partie à réflecteur de Bragg (22, 23, 24), et des moyens (14, 15) servant à fournir un courant électrique à ladite partie active, ladite partie active étant supportée par un premier substrat (11), et ladite partie à réflecteur de Bragg étant supportée par un second substrat (21), ladite partie à réflecteur de Bragg étant susceptible de supporter au moins deux modes de rayonnement optique.

2. Laser selon la revendication 1, ledit premier substrat étant essentiellement en un matériau du groupe III-V.

3. Laser selon la revendication 1 ou la revendication 2, ledit second substrat étant essentiellement en silicium.

4. Laser selon la revendication 3, ladite partie à réflecteur de Bragg comprenant une zone de noyau diélectrique (23), à base de silicium.

5. Laser selon la revendication 4, ladite zone de noyau étant située entre des zones de placage (22, 24) comprenant du dioxyde de silicium.

6. Laser selon l'une quelconque des revendications précédentes, ladite partie à réflecteur de Bragg comprenant un réseau enterré.

7. Laser selon l'une quelconque des revendications précédentes, ledit premier substrat étant fixé audit second substrat.

8. Laser selon la revendication 7, ledit second substrat étant aligné par rapport audit premier substrat, au moyen de détails superficiels formés par gravure sélective (111, 112, 211, 212).

9. Laser selon la revendication 7 ou la revendication 8, comprenant une connexion soudée (25), entre ledit premier substrat et ledit second substrat.

10. Laser selon l'une quelconque des revendications précédentes, ladite partie à réflecteur de Bragg comprenant un guide d'ondes effilé.

11. Laser selon l'une quelconque des revendications 1 à 6, ladite partie active de laser étant fixée à une sous-monture fixée audit second substrat.

12. Laser selon la revendication 11, ladite sous-monture étant alignée par rapport audit second substrat, au moyen de détails superficiels formés par gravure sélective.

13. Emetteur optique, comprenant un laser de communication optique selon l'une quelconque des revendications précédentes et une liaison par fibre optique, comprenant un détail superficiel formé par gravure sélective, pour assurer l'alignement d'une fibre optique avec ledit laser.
